(19) **Europäisches Patentamt**

**European Patent Office**

**Office européen des brevets**

(11) **EP 1 376 185 A2**

(12) **EUROPEAN PATENT APPLICATION**

(43) Date of publication:
02.01.2004 Bulletin 2004/01

(51) Int Cl.7: **G02B 7/18**

(21) Application number: **03013982.8**

(22) Date of filing: **20.06.2003**

| (84) Designated Contracting States: **AT BE BG CH CY CZ DE DK EE ES FI FR GB GR HU IE IT LI LU MC NL PT RO SE SI SK TR** Designated Extension States: **AL LT LV MK** | (71) Applicant: **Nikon Corporation Tokyo 100-8331 (JP)** |
| --- | --- |
| (30) Priority: **20.06.2002 US 390293 P 04.06.2003 US 455750 P** | (72) Inventor: **Sogard, Michael Menlo Park, CA 94025 (US)** (74) Representative: **Viering, Jentschura & Partner Patent- und Rechtsanwälte, Steinsdorfstr. 6 80538 München (DE)** |

(54) **Minimizing thermal distortion effects on EUV mirror**

(57)     A mirror is provided with throughholes, or channels, formed through its main body and a coolant pipe of a heat-conductive material is inserted in each of the channels for passing a cooling fluid inside. The outer wall of the coolant pipe does not contact the inner wall of the channel, and there is left a gap in between. The gap contains a heat-conducting gas such as helium. The gap is of a width of less than 100 µm such that the gas has a high heat transfer coefficient even if its pressure is not too high. In some applications the gap may be filled with a heat-conductive fluid. It may be preferable, depending upon the circumstances, to form these channels proximally to the surface on which radiation is made incident. Additionally, the surface of the side of the mirror opposite the reflective side may be heated by auxiliary heat sources.

**FIG. 1A**

EP 1 376 185 A2

**Description**

**BACKGROUND OF THE INVENTION**

This invention is in the technical field of mirrors such as extreme ultraviolet (EUV) mirrors and relates in particular to the problem of minimizing thermal distortion effects on such a mirror.

The EUV mirror absorbs significant amounts of heat from the EUV radiation primarily because its reflectivity is not very high. The absorbed heat causes distortion of the mirror surface from thermal expansion effects. The distortion in turn leads to optical aberrations and hence must be minimized as much as possible by whatever means. The thermal distortion has been modeled and is generally considered to consist of (1) a local distortion which is associated with the local temperature distortion, and (2) a so-called "global distortion" which is related to thermal stresses which alter the shape of the entire mirror. Both of these types of distortion must be appropriately dealt with. The present invention relates to the problem of global distortion.

The global distortion depends both on the thermal and mechanical boundary conditions and constraints, and on the details of the mirror design and illumination pattern. In some studies, it is assumed that the back of the mirror is in contact with a temperature reservoir. This may be expected to minimize distortion because a maximum amount of heat can thus be removed, but this may be true only with regard to the local distortions. Since the heated front surface coupled with the cooled back surface creates a temperature gradient in the direction approximately perpendicular to the mirror surface, this may lead to "bowing" of the mirror. If the mirror is held kinematically, nothing will prevent such a bowing effect. Thus, such a cooling technique should be avoided, unless the back of the mirror can be attached to a base plate which is a part of the temperature reservoir and is rigid enough to prevent the mirror from bowing. Local distortions will still remain.

**SUMMARY OF THE INVENTION**

An EUV mirror embodying this invention may be characterized as having throughholes, or channels, formed within the mirror member and a coolant pipe of a heat-conductive material inserted in each of the channels for passing a cooling fluid inside, its outer wall not contacting the wall of the channel but leaving a gap in between. It may be preferable to form these channels proximally to the surface on which light in made incident. The gap contains a gas with high thermal conductivity such as helium which is maintained below atmospheric pressure. The gap is of a width of less than 100 μm such that the gas has a high heat transfer coefficient even if its pressure is not too high. The coolant flow may be highly turbulent, to further increase heat transfer from the mirror. Additionally, the mirror may be heated on its rear surface, the surface opposite the reflective surface, to eliminate residual global thermal distortion. In other applications the gap may contain a thermally conductive fluid maintained at a pressure comparable to the ambient pressure surrounding the mirror.

**BRIEF DESCRIPTION OF THE DRAWING**

The invention, together with further objects and advantages thereof, may best be understood with reference to the following description taken in conjunction with the accompanying drawings in which:

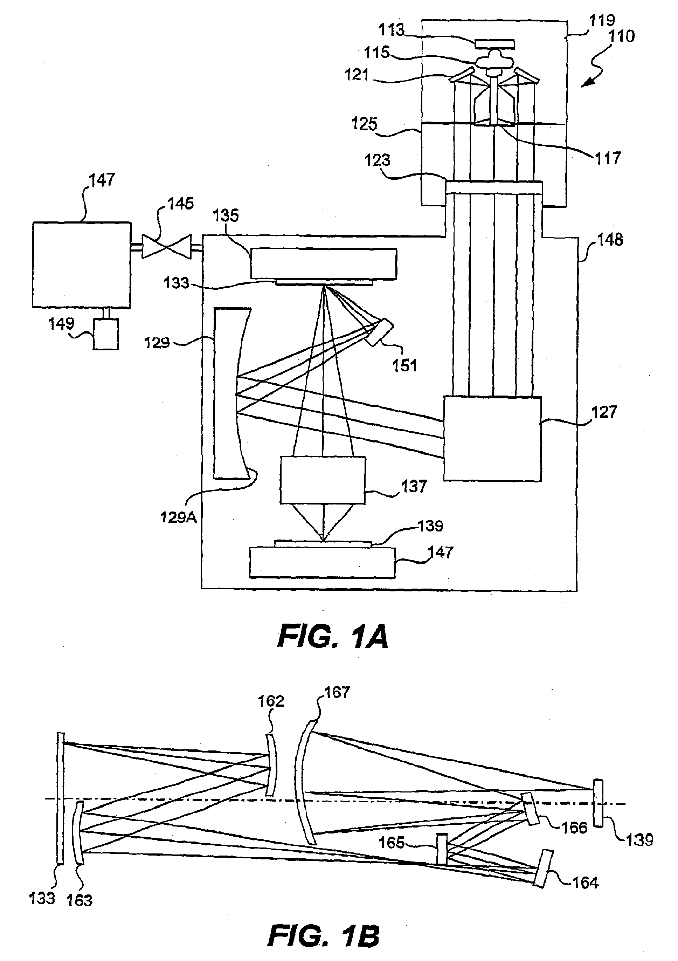

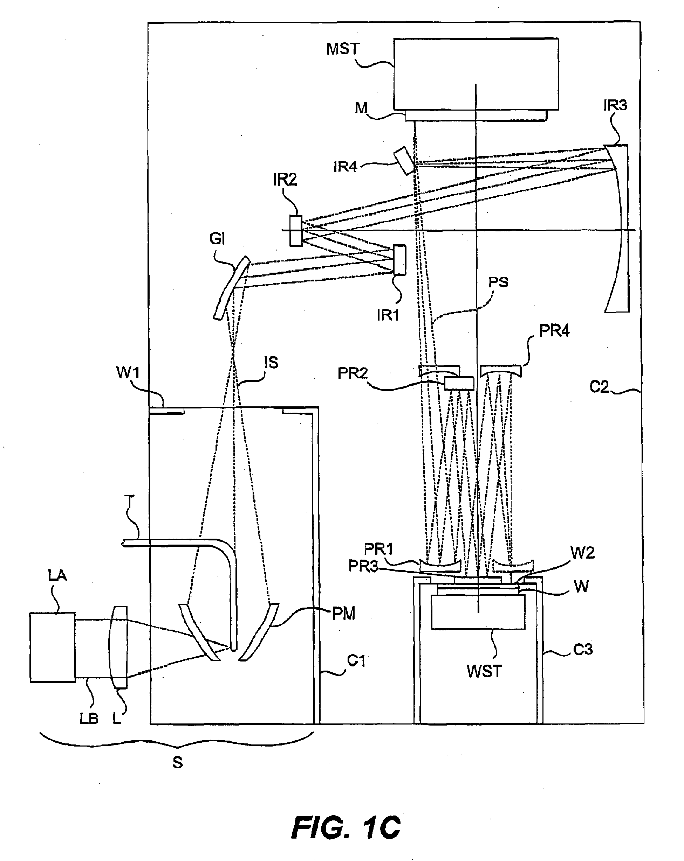

Fig. 1A is a schematic optical diagram of a representative embodiment of an X-ray microlithography system comprising at least one multilayer-film reflective optical element according to any of the embodiments of this invention, Fig 1B is a detailed view of the projection-optical system of the microlithography system shown in Fig. 1A, and Fig. 1C is a schematic optical diagram of another representative embodiment of an X-ray microlithography system comprising at least one multilayer-film reflective optical element (including a reflective reticle) according to any of the embodiments of this invention;

Fig. 2 is a process flow diagram illustrating an exemplary process by which semiconductor devices are fabricated by using the apparatus shown in Fig. 1 according to the present invention;

Fig. 3 is a flowchart of the wafer processing step shown in Fig. 2 in the case of fabricating semiconductor devices according to the present invention;

Fig. 4 is a schematic drawing of an EUV mirror system embodying this invention, including a EUV mirror of which a schematic sectional view is included;

Fig. 5A is a schematic sectional view of one of the cooling channels and Fig. 5B is a schematic sectional view of a cooling channel having more than one pipe (two pipes) therethrough;

Fig. 6 is a graph showing the relationship between the heat transfer coefficient of helium gas in a gap and its pressure for different gap widths;

Fig. 7 shows the heat transfer coefficient of the coolant within the cooling tube for conditions of a full turbulent flow and a laminar flow;

Fig. 8A is a schematic sectional view of a cooling system embodying the invention;

Fig. 8B is a schematic sectional view of the cooling system of Fig. 8A;

Fig. 8C is a schematic sectional view of another cooling system embodying the invention;

Fig. 8D a schematic sectional view of another embodiment of the cooling channels;

Figs. 9A and 9B are schematic sectional views of still another cooling system embodying the invention, Fig. 9A being a sectional view taken along line 9A-9A of Fig. 9B and Fig. 9B is a sectional view taken along line 9B-9B of Fig. 9A;

Fig. 10 defines the terms and coordinate system describing the temperature distribution in the mirror;

Fig. 11 is a schematic which defines cooling planes relative to the cooling channels;

Fig. 12 shows an embodiment of a control system which provides appropriate heating to the back surface of the mirror;

Fig. 13 shows an embodiment of a radiant heating system for the back surface of the mirror;

Fig. 14 shows an embodiment of a heating system with a remote radiation source which is projected onto the back of the mirror;

Fig. 15 shows another embodiment of part of a projection heating system for the back surface of the mirror; and

Fig. 16 is a schematic illustration of another embodiment of a projection heating system which can provide real time correction to the radiation intensity distribution at the back of the mirror.

## DETAILED DESCRIPTION OF THE INVENTION

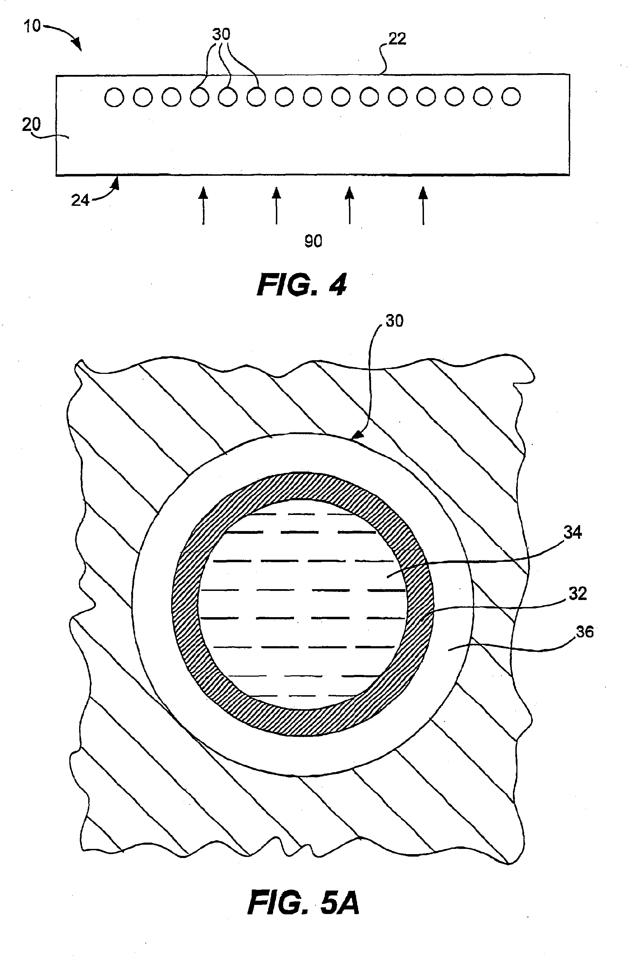

Fig. 4 shows schematically an EUV mirror system 10 embodying this invention, including an EUV mirror 20 with a front surface 22 and a back surface 24. The front surface 22 is where EUV illumination is intended to impinge. The mirror surface is normally curved and is assumed to possess, at least to a near approximation, axial symmetry. Throughholes (serving as cooling channels) 30 are provided through the mirror 20, lying in a plane approximately perpendicular to the axis of symmetry. The cooling channels 30 may serve to cause a cooling fluid (not shown) to flow therethrough. Since the coolant may be approximately of an atmospheric pressure or more while the mirror 20 typically operates in a vacuum environment, this pressure difference tends to cause some distortion of the mirror 20. One method of eliminating the effects of such distortion is to preliminarily polish the mirror 20 with the channels 30 over-pressurized by a specified amount such as one atmosphere, such that this distortion effect will be preliminarily polished out. However, to completely eliminate the distortion effect, this method must include the pressure drop suffered by the fluid along the channel length, which is caused by the fluid's viscosity. Also shown is an auxiliary source of heat 90 which heats the surface of the mirror opposite the reflective side. This heat source creates thermal stresses in the mirror opposite to those created by the illumination irradiating the reflective side, thereby canceling their effects.

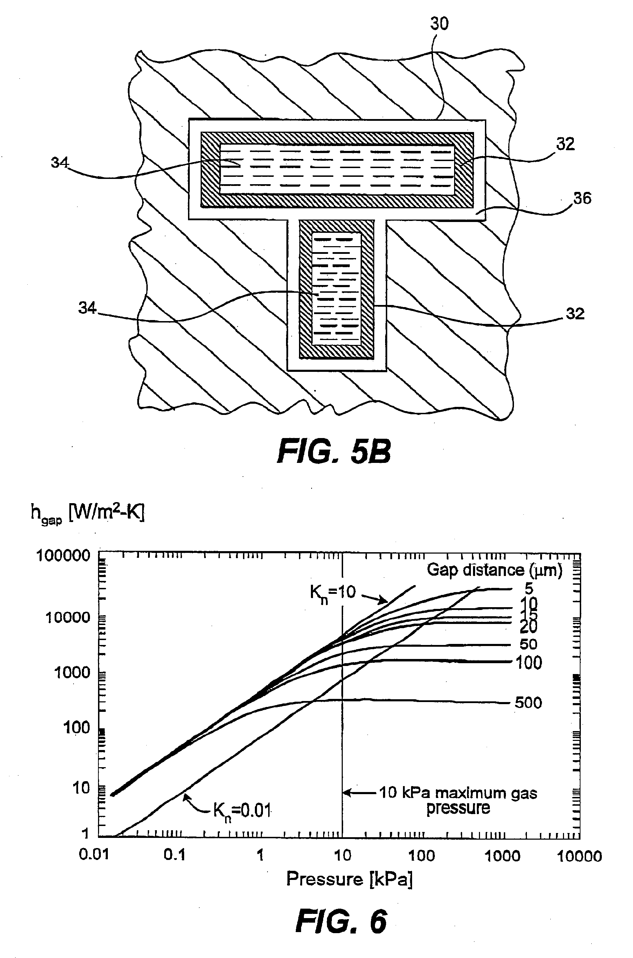

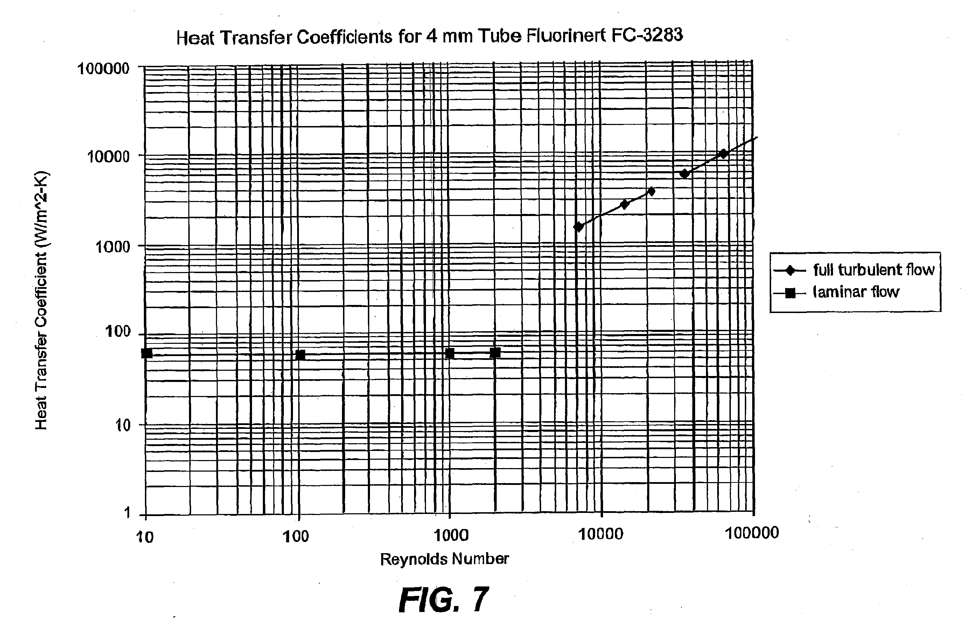

Another approach is, as shown in Fig. 5A, to provide a pipe (or a conduit) 32 inside each cooling channel 30. The pipe 32 is made of a material with high thermal conductivity and a cooling fluid 34 flows therethrough. As shown in Fig. 5A, the channel 30 is sufficiently oversized that the pipe 32 therein does not contact the inner wall of the channel 30, leaving an annular gap 36 therebetween. The gap 36 between the inner wall of the channel 30 and the pipe 32 is filled with a gas of high thermal conductivity, such as helium gas, for conducting heat between the material of the mirror 20 and the coolant inside the pipe 32. It now goes without saying that the cross-sectional shape of the channels need not be circular and that one channel may contain two or more pipes inside, as shown in Fig. 5B.

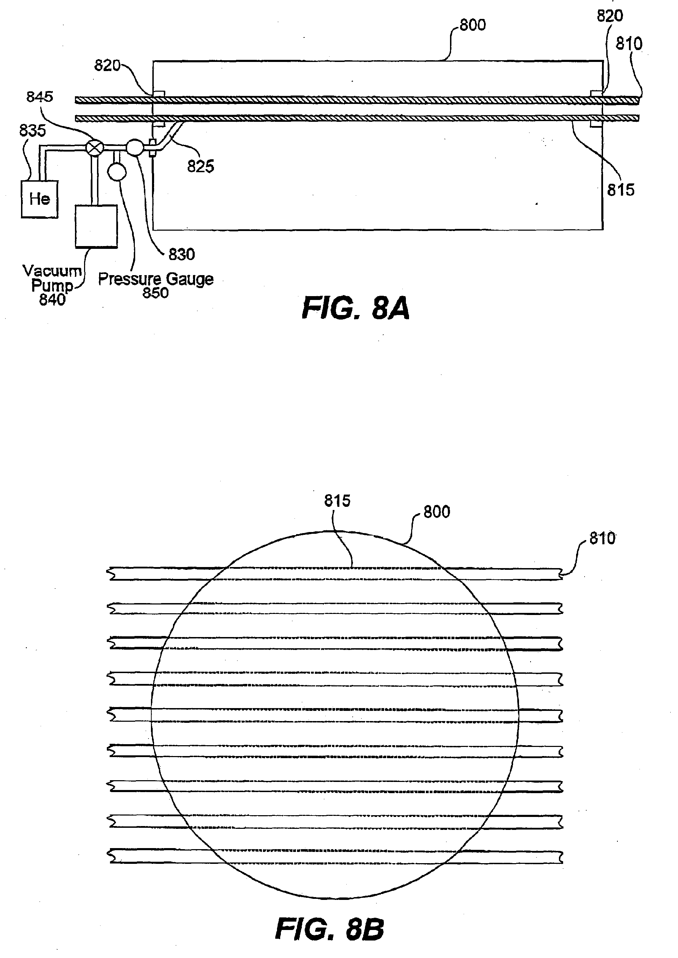

Fig. 6 shows the relationship between the heat transfer coefficient of helium gas in a gap and its pressure for different gap widths. The heat transfer coefficient increases with pressure in a lower pressure range but the rate of variation decreases at higher pressures. Fig. 6 also shows that the heat transfer coefficient remains relatively high even at lower pressures if the gap width is small. For a gap of the order of a few tens of microns or less, the helium gas may be maintained at a fraction of one atmosphere with little reduction in thermal conductivity, thereby reducing pressure distortion of the mirror 20. For example, a pressure of 10 kPa is just one tenth of atmospheric pressure, yet relatively high thermal conductivities remain attainable at that pressure. For the purpose of the present invention, the width of the gap is set less than 100μm and preferably less than 50μm.

If the mirror material above the channel 30 is approximated by a plate of thickness $t_1$, the deformation from the pressure P in the channel may be estimated from the theory of bending of elastic beams under load. If the width of the channel (the channel dimension approximately parallel to the mirror surface) is c, the maximum deformation d of the plate normal to the plane of the mirror is given by

$$d = Pc^4/32Et_1^3, \qquad\qquad (1)$$

where E is Young's modulus for the mirror material. The deformation of the mirror is linearly proportional to the pressure in the channel, so reducing the pressure by a factor of 10 also reduces the deformation by a factor of 10. Alternatively, Eq. 1 shows that for a given amount of deformation, reducing P by a factor of 10 means the distance $t_1$ may be reduced by the factor $10^{1/3} = 2.15$, so the channels may be located closer to the mirror surface.

Fig. 7 shows the heat transfer coefficient of a typical cooling fluid (Fluorinert FC-3283, manufactured by 3M Corp. of Minneapolis, MN) as a function of Reynolds number for the cases of laminar flow and full turbulent flow. The Reynolds number R is defined by $R = \rho Dv/\eta$, where $\rho$ is the coolant density, D is the coolant pipe inner diameter, v is the coolant flow velocity along the pipe axis, and $\eta$ is the coolant viscosity. Creating full turbulent flow conditions increases the heat transfer by several orders of magnitude compared to the case of laminar flow. The expressions used to calculate these results are described in the article "Some fundamentals of cooled mirrors for synchrotron radiation beam lines" by M. Howells in Optical Engineering **35**, 1187(1995), the contents of which are incorporated herein by reference. However, associated with turbulent flow are pressure fluctuations in the fluid which can create vibrations. Such behavior is absent in laminar flow, so laminar flow conditions have typically been used in the prior art when high mechanical stability of the mirror surface is required. Because the coolant pipe is mechanically isolated from the mirror by the gap, turbulent flow may be employed with the present invention, thereby permitting higher heat transfers to be achieved. Although the cooling fluid is typically a liquid, it might also be a gas.

To illustrate the advantage of the present invention a calculation was done, comparing the thermal resistance between the mirror material and the coolant flowing through a channel under laminar flow conditions (prior art), and the thermal resistance associated with heat flow from the mirror material through a 50 μm He gas gap, a copper tube, and into the coolant flowing within the tube under full turbulent flow conditions. For a given temperature difference between two points, heat flow is inversely proportional to the intervening thermal resistance, so a lower thermal resistance permits higher heat transfer. The copper tube was assumed to have 4 mm inner diameter and 0.5 mm wall thickness. Based on the information presented in Figs. 6 and 7, the heat transfer coefficients for the He gas and the coolant flowing under turbulent conditions were assumed to be 1000 $W/m^2$-K, and the heat transfer coefficient for the coolant flowing under laminar conditions was assumed to be 58 $W/m^2$-K. Under these conditions the thermal resistance associated with the prior art case was found to be approximately 17 times larger than that associated with the present invention. Therefore heat transfers out of the mirror material can be greater than an order of magnitude higher with the present invention.

A preferred position for providing the channels 30 is difficult to determine because there are many factors to be taken into consideration. A model calculation was carried out for a mirror in the shape of a circular disk of radius r being heated uniformly from one side (on the top surface). The channels 30 are assumed to be in a plane (the "cooling plane") at distance $t_1$ from the top surface which is uniformly heated and at distance $t_2$ from the opposite surface, the total thickness of the mirror being $t = t_1 + t_2$. Thus, a uniform temperature gradient is assumed over a distance (in the direction of the thickness) of $t_1$ and the temperature is assumed to be constant over the adjacent distance of $t_2$. The temperature gradient causes the entire disk to deform and the question is how the deformation changes as $t_1$ is varied.

The deformation was calculated by stress and strain formulas in Table 24 of Roark and Young ("Roark's Formulas for Stress and Strain," McGraw-Hill, 6th ed.), the contents of which are incorporated herein by reference, which were applied by using the assumption that the disk is separated at the cooling plane into a thermally stressed top plate and a bottom plate which is deformed by the application of moments along its periphery into a spherical cap. Thermal stress alone will deform the upper plate into a spherical cap. An application of additional moments along its periphery will change its radius of curvature to match that of the lower plate such that they join together. A final deformation is calculated on the further requirement that the stress of the bottom surface of the top plate be equal to that of the top surface of the bottom plate. The final displacement y of the plate center thus calculated is in the form of $y = (r^2 \gamma \Delta T/2)/(t_1+t_2)$ where $\gamma$ is the coefficient of thermal expansion and $\Delta T$ indicates the temperature difference through the thickness of the top plate. This equation suggests that it does not matter where the cooling plane is. However, for a plate heated on one side by a constant heat flux F and cooled by a temperature reservoir on the other side, the temperature difference $\Delta T$ between the two sides scales with the quantity $\Delta T=Ft_1/K$ where K is the thermal conductivity of the material according to Carslaw and Jaeger in Section III.8 of "Conduction of Heat in Solids," Oxford, the contents of which are incorporated herein by reference. It is assumed here and below that the heat flux F represents that part of the incident flux which is absorbed by the surface. Therefore, the deformation y is in fact proportional to $t_1$, and the conclusion hereby obtained is that the cooling plane should be as close to the heated surface as possible.

There are factors that limit how small $t_1$ can be made. If the cooling network involves channels machined within the mirror, they must be far enough from the mirror surface such that they will not influence the mirror figure. As explained above, the helium gas in the gap 36 is maintained at a low pressure to reduce distortion of the mirror surface, while the gap is small enough to ensure a high heat transfer coefficient. However, if the channels are very close to the mirror surface, the material directly above the channels may experience a slightly larger temperature gradient than material lying in a plane midway between adjacent channels. This could contribute to local temperature distortion of the mirror. In the above cited paper, Howells teaches that $t_1$ should be at least several times the channel width to avoid local distortion effects. He also teaches that forces from polishing and coolant pressure dictate a practical range for $t_1$ of approximately 0.5 mm to 5 mm. Since coolant pressure is significantly reduced in this invention, smaller values of $t_1$ may be allowed.

The coolant 34 flowing within the cooling pipe 36 may be in a turbulent state for higher heat transfer, but the consequent vibrations should not perturb the mirror surface. Successful application of this invention requires that the cooling pipes be mechanically isolated from the mirror while remaining surrounded by a controlled atmosphere of He gas. Some embodiments are described which satisfy these requirements. Figs. 8A and 8B show schematic views of a mirror 800 with a series of cooling pipes 810 running through parallel channels 815 in the mirror. Each pipe is centered in its channel, and the channels are sealed at the mirror periphery by compliant seals 820 made of rubber or some other visco-elastic material. The compliant seals will help to isolate and damp any vibrations the pipe experiences from turbulent fluid motion. He gas or some other high thermal conductivity gas is admitted to each channel through an inlet 825 which is connected to a gas manifold 830. The gas pressure in the manifold 830 and the mirror channels 815 is controlled by means of a He gas supply 835, a vacuum pump 840, a valve 845 to switch between them, a pressure gauge 850, and a gas pressure controller (not shown). The coolant pipes run to a coolant manifold (not shown) which directs coolant to them from a reservoir which may be part of a closed loop system involving a heat exchanger and temperature controller (not shown). Such coolant systems are well known in the art.

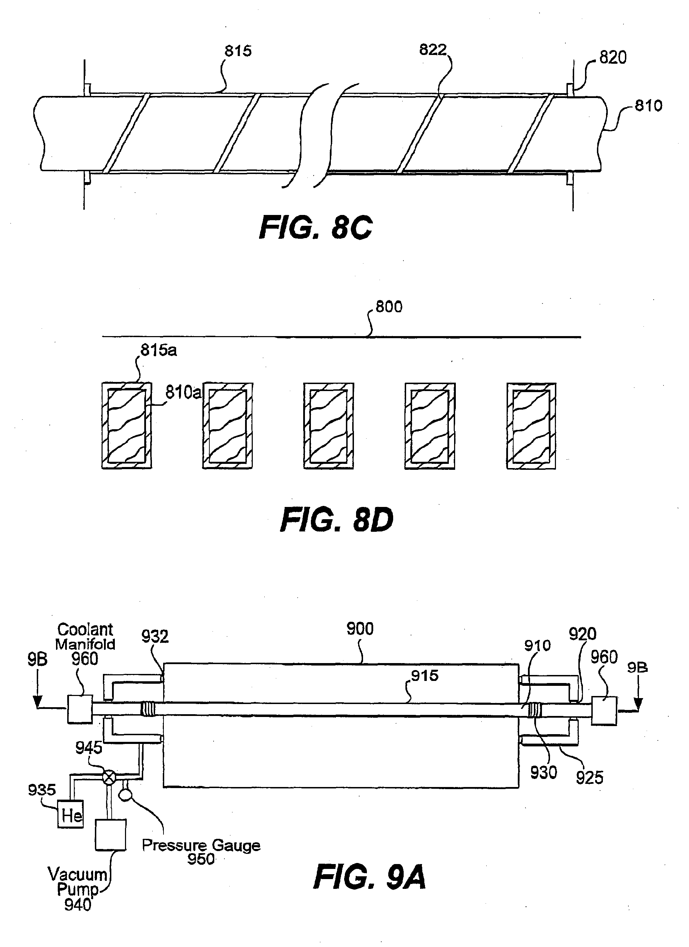

Fig. 8C shows a coolant pipe 810 within a channel 815. The channel has visco-elastic gas tight seals 820 at the mirror periphery. In addition, the pipe is centered within the channel by means of a helical coil 822 of visco-elastic material. This coil will also help to damp any vibrations the pipe experiences from turbulent fluid motion in the coolant. Other designs, employing spacers made of visco-elastic material may also be used.

Fig. 8D shows a cross section of several channels 815a and coolant pipes 810a with a rectangular rather than circular cross section. The paper by Howells teaches that a tall, narrow rectangular geometry provides superior heat transfer capabilities over a circular cross section, when overall heat transfer is limited by convection in the coolant. When overall heat transfer is limited by conduction in the mirror material, the shape of the channels is less important.

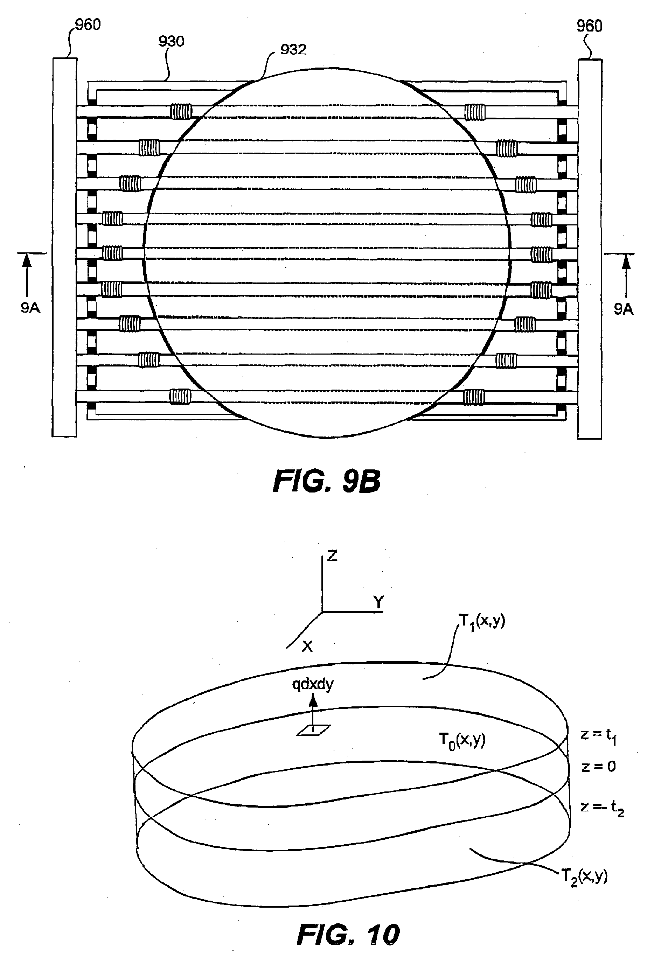

Figs. 9A and 9B show an embodiment where coolant pipes 910 are further mechanically isolated from the mirror 900. The pipes make no mechanical contact with the mirror. They are positioned relative to the channels 915 by a rigid framework (not shown) which is referenced to the mirror or its mounts but isolated from it by visco-elastic damping units. The coolant pipes are enclosed in a He gas manifold 930. A bellows 925 or other flexible connection serves to isolate the pipes from any stresses associated with the visco-elastic gas seals 920 at the ports of the manifold 930. The pipes connect to coolant manifolds 960 and the rest of the coolant system (not shown). The gas manifolds are sealed to the mirror through compliant visco-elastic seals 932. The gas pressure in the manifold 930 and the mirror channels 915 is controlled by means of a He gas supply 935, a vacuum pump 940, a valve 945 to switch between them, and a pressure gauge 950. The only mechanical connection to the mirror in this case is at the mirror periphery.

As mentioned previously, the He gas pressure is maintained at a small fraction of an atmosphere, so pressure distortion of the mirror surface is small. Also, vibrations of the coolant pipe caused by turbulent flow are isolated from the mirror by visco-elastic seals and spacers. Nevertheless, some vibrations could be transmitted to the mirror through the gas as sound waves. This contribution is expected to be very small, as a simple argument shows. Sound waves generated in the coolant propagate through the coolant tube and then through the gas. Since the gap between the coolant pipe and the mirror is small, we treat the sound propagation as being one-dimensional. At the outer surface of the coolant pipe, part of the sound waves are transmitted into the gas and the rest is reflected back into the pipe. For simplicity we assume that all of the transmitted energy is subsequently absorbed by the mirror. The fraction of vibrational energy transmitted into the gas depends on the relative density of the two media as well as their speeds of sound and is given approximately by

$$\text{transmitted fraction} = 4\rho_{gas}c_{gas}/\rho_{pipe}c_{pipe}, \tag{2}$$

where $\rho$ is the density of the medium and $c$ is the speed of sound. This expression is derived in Section 33.6 of B. Yavor and A. Detlaf, Handbook of Physics, Mir Publishers, 1975, the contents of which are incorporated herein by reference, for the case where $\rho_{gas}c_{gas} \ll \rho_{pipe}c_{pipe}$. For He gas, $\rho_{gas} \approx 0.0166$ kg/m$^3$ and $c_{gas} \approx 1000$ m/sec, at 20 °C and a pressure of 10 kPa. If the coolant pipe is made of copper, the corresponding quantities are $\rho_{pipe} \approx 8930$ kg/m$^3$ and $c_{pipe} \approx 3750$ m/sec. As a result the fraction of vibrational energy transmitted into the gas, and assumed to ultimately be absorbed by the mirror, is only approximately $2\times10^{-6}$. Therefore the gas layer is very effective in decoupling vibrations of the coolant pipe from the mirror.

Although the embodiments described above show straight coolant pipes lying within straight channels in the mirror, other geometries are possible as well. If there is an advantage for example in having curved pipes within similarly curved channels, the mirror could be fabricated in two parts, split at a plane where the pipes will lie. Channels in the two mating surfaces could be suitably machined, the pipes inserted, and the two halves bonded together. For some geometries, separation of the mirror into more than two pieces may be required.

In some cases a thermally conductive fluid may be substituted for the gas in the gap between the coolant pipe and the mirror channel. The fluid is chosen to maintain its liquid and thermal properties at the operating temperature and ambient pressure of the mirror. For example the mirror might operate at atmospheric pressure, so the fluid would be maintained at atmospheric pressure. The coolant within the pipe could then have pressures different from an atmosphere without perturbing the mirror surface. The pressure required to provide a given flow of fluid through a pipe of a given diameter, and therefore a specified heat transfer, is a strong function of both the flow rate and the pipe diameter, so the pressure within the pipe will usually differ from the ambient pressure. In addition, fluid flowing in a pipe suffers a significant pressure drop along the length of the pipe because of the fluid's viscosity. The effects of this pressure gradient on mirror distortion would thus be avoided. Vibrations associated with coolant turbulence within the pipe would not be as isolated from the mirror as in the case of a gas filling the gap, but some lesser vibration isolation remains. Assuming the fluid in the gap to be water of density 1000 kg/m$^3$ and speed of sound approximately 1500 m/sec, and a copper pipe, Eq. 2 estimates the fraction of vibrational energy transmitted to the mirror to be approximately 0.18. For example, the thermal conductivity of water exceeds that of He gas, so enhanced cooling is possible. However, the fluid heat capacity will be much greater than that of a the gas, and this may complicate temperature control of the mirror unless the fluid is circulated. By keeping the gap small, the heat capacity of the fluid can be minimized.

Providing a plane of cooling channels near the heated surface of the mirror reduces the global thermal deformation of the mirror as shown above. Any residual undesired global thermal deformation may be eliminated by applying a distribution of heat sources to the bottom of the mirror, so that thermal stresses in the mirror below and above the cooling plane cancel out. A fairly general statement can be made about these heat sources, using an argument similar to the one above concerning the optimum placement of the cooling plane. Again, treating the mirror as a flat plate, divide the plate at the cooling plane into an upper plate and a lower plate. Assume the temperature distribution at the top surface is given by $T_1(x, y)$, and the temperature distribution in the cooling plane is given by $T_c(x, y)$, as shown in Fig. 10. In a steady state situation the temperature distribution in an intermediate plane at height $z$ can be written as

$$T(x, y) = T_c(x, y) + (T_1(x, y) - T_c(x, y))z/t_1 \equiv T_c(x, y) + \Delta T_1(x, y)z/t_1. \tag{3}$$

The term $T_c(x, y)$ will cause thermal distortion in the x-y plane but not in z. Only the thermal gradient term $\Delta T_1(x, y)z/t_1$ will cause out-of-plane deformation of the plate. According to a theorem by J. Goodier in ASME J. Applied Mechanics **24**, 467(1957), the contents of which are incorporated herein by reference, the out-of-plane deformation can be canceled by applying a distributed load $q_1(x, y)$ in the z direction over the surface of the plate:

$$q_1(x, y) = \frac{Et_1^2}{12(1-\nu)}\left(\frac{\partial^2}{\partial x^2} + \frac{\partial^2}{\partial y^2}\right)\gamma\Delta T_1(x, y). \tag{4}$$

where E is Young's modulus and $\nu$ is Poisson's ratio for the plate material.

Similarly, if the temperature distribution on the bottom surface is given by $T_2(x, y)$, we can describe the temperature at an intermediate plane by

$$T(x, y) = T_c(x, y) + (T_c(x, y) - T_2(x, y))z/t_2 \equiv T_c(x, y) + \Delta T_2(x, y)z/t_2. \tag{5}$$

Again the lower plate can be flattened by the application of a distributed load $q_2(x, y)$, where

$$q_2(x, y) = \frac{Et_2^2}{12(1-\nu)}\left(\frac{\partial^2}{\partial x^2} + \frac{\partial^2}{\partial y^2}\right)\gamma\Delta T_2(x, y). \tag{6}$$

By adjusting the temperature distribution $T_2(x, y)$ so that $q_1(x, y) + q_2(x, y) = 0$, we can cancel out the thermal stresses in the upper and lower parts of the plate, so that the entire plate (mirror) remains flat. This condition can be shown to be equivalent to

$$\Delta T_2(x, y) = \frac{t_1^2}{t_2^2}\Delta T_1(x, y). \tag{7}$$

So the temperature difference $\Delta T_2(x, y)$ required between the cooling plane and the bottom plate is less than that in the upper part of the plate by the ratio $(t_1/t_2)^2$, and since we saw above that the best cooling geometry minimizes $t_1$ compared to $t_2$, this ratio will typically be quite small. Furthermore, if the variation in the temperature differences with position in x and y is relatively small, we can assume the heat absorbed at the surfaces which creates the temperature differences scales approximately like $\Delta T_1 = F_1 t_1/K$ and $\Delta T_2 = F_2 t_2/K$, as described in the Carslaw and Jaeger reference above. Then the heat absorbed at the bottom surface of the plate which is required to flatten the plate will scale with the heat absorbed at the top of the plate like

$$F_2(x, y) = (t_1/t_2)^3 F_1(x, y). \tag{8}$$

Thus, relatively little additional heat should be needed to flatten the plate if $t_1$ is less than $t_2$.

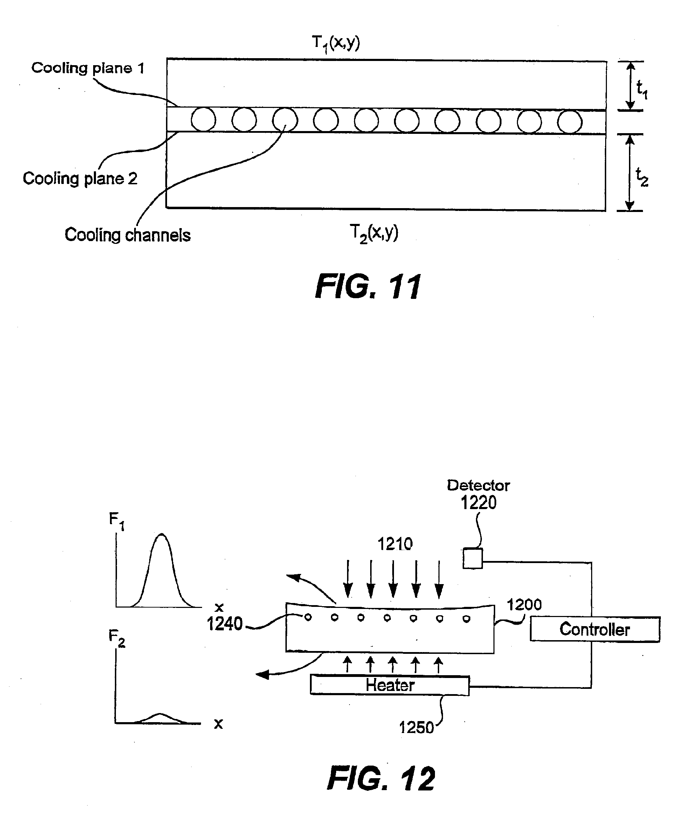

The result in Eq. 7 is fairly general, since it does not require the cooling plane to be isothermal. However, if cooling is accomplished by circulating coolant through channels, the approximation of a single plane, in which cooling takes place, may not be justified. A more realistic situation is shown in Fig. 11. Unless a very high cooling rate is needed, the temperature in the coolant channels is not likely to be significantly different at the top and bottom of the channels. Therefore, the temperature distributions at the cooling planes 1 and 2 should be almost identical. Then, the arguments made above should apply to this case as well. The distances $t_1$ and $t_2$ are more accurately defined as in Fig. 11 now.

Eq. 7 is an approximation, because it neglects any variation in $t_1$ associated with the mirror surface curvature. Therefore, a correction must be determined either empirically or by modeling. Similarly, some correction to Eq. 8 must be determined either empirically or by modeling to compensate for variations in both $t_1$ and the variation in temperature differences with position on the mirror. If the mirror curvature is gentle and the temperature differences don't change very much, however, Eqs. 7 and 8 should give reasonable approximations to the final relationships.

Fig. 12 shows an embodiment of a control system which provides appropriate heating to the back of the mirror 1200, to eliminate global thermal distortion. The radiation 1210 incident on the mirror surface is monitored by a detector 1220 or detectors, and the absorbed radiation flux $F_1(x, y)$ determined from the known absorption properties of the mirror. Alternatively, a separate monitor (not shown) could measure the surface temperature distribution of the mirror. A controller 1230 uses the absorbed surface flux, or surface temperature, along with information describing the coolant channel 1240 conditions to determine from models the required absorbed heat flux $F_2(x, y)$ on the back of the mirror. The controller then controls a heat source ("heater") 1250 to provide the necessary heat flux. The models in the controller will be based on the relations in Eqs. 7 and 8, along with corrections to them.

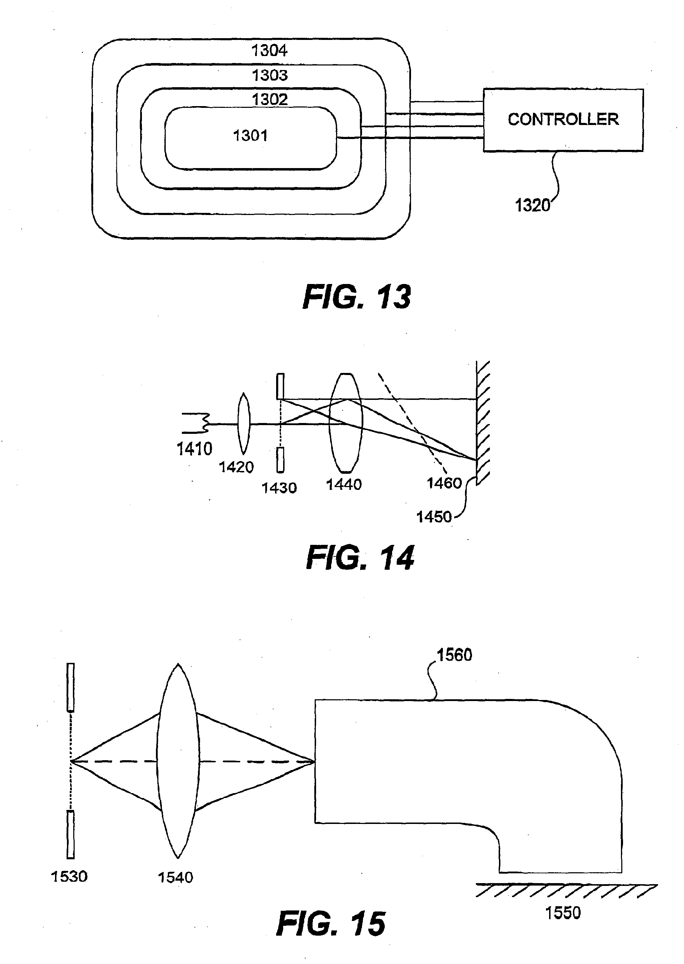

The heat source could provide radiant heating of the mirror back from close proximity. Or the heat source could be in contact with the mirror back and heat it directly. Or the heat source could be a remote source of radiation which is modulated appropriately and projected onto the mirror back by means of an optical system. Fig. 13 shows an embodiment of a radiant heating system. It consists of a number of bodies lying in a flat plane, temperatures of which may be adjusted independently. For example, each body may be heated by an array of resistive heaters of which electrical current is controlled. Or they may be heated by a flow of fluid heated remotely by heaters (not shown). These bodies may be proximal to the mirror back or they may be in physical contact with it. In Fig. 13, regions 1301, 1302, 1303, and 1304 represent bodies approximately thermally isolated from one another, each of which is approximately isothermal. A controller 1320 supplies the appropriate energy to each body. In this embodiment, the geometry of the bodies must be predetermined, based on the anticipated flux distribution on the mirror surface. Therefore it is not very flexible. However, it may represent a fairly compact system, which may be advantageous if the mirror has little space available for the heating system.

Fig. 14 shows an embodiment of a heating system with a remote radiation source which is projected onto the back of the mirror 1450. A source of radiation 1410 may be incoherent or coherent. It may be broadband or it may be in the ultraviolet or shorter wavelength part of the spectrum, or it may be visible radiation , or it may be infrared. Ideally the radiation will be efficiently absorbed by the mirror back 1450. The mirror back may be coated with a film or its surface otherwise treated to enhance the absorption. The radiation is projected onto a mask 1430 by a condenser lens 1420 or lenses. The mask alters the distribution of the radiation intensity, so that when it is projected onto the mirror back 1450 by a projection lens 1440 or lenses, it provides the desired flux distribution. Additional optical subsystems (not shown) may be used to homogenize the radiation distribution before it illuminates the mask. Because of space considerations, the complete optical system may not have room to fit behind the mirror. Therefore a mirror 1460, maybe included to redirect the radiation distribution to the mirror from the side.

Fig. 15 shows another embodiment of part of a projection heating system. Radiation from a mask 1530 is imaged by a projection lens 1540 onto the proximal end of a bundle of optical fibers 1560. The fibers are arranged parallel to one another, so that the radiation distribution is faithfully reproduced at the distal end of the bundle which is proximal to the back of the mirror 1550. Such an embodiment may be useful in a situation where little space is available behind the mirror.

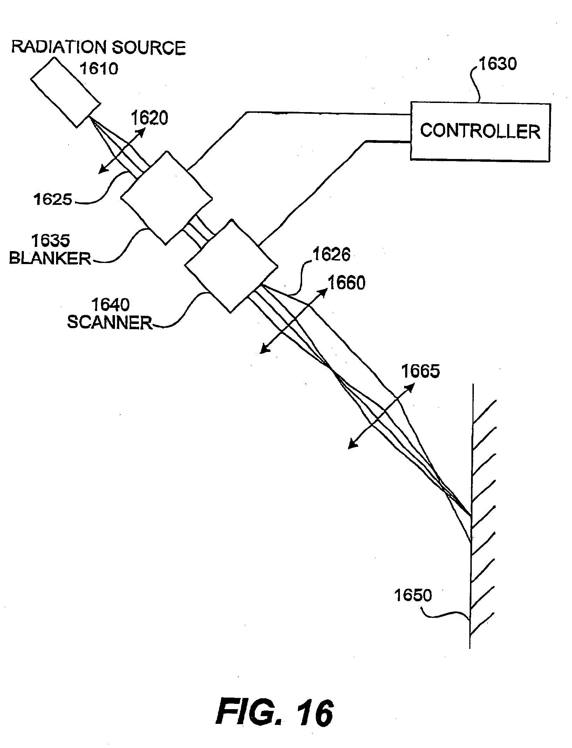

Figure 16 is a schematic illustration of still another embodiment of a projection heating system which can provide real time correction to the radiation intensity distribution at the back of the mirror 1650. A radiation source 1610 and a lens system 1620, comprising one or more lenses, produce a small collimated beam 1625. The collimated beam 1625 passes through a blanker 1635, which blanks (interrupts) the collimated beam 1625 on command from a controller 1630. The collimated beam 1625 then passes through a scanner 1640 which deflects the collimated beam 1625 under command from the controller 1630. A central ray 1626 of the deflected beam is shown. A lens 1660 collects the deflected beam 1626, and a second projection lens 1665 focuses it on the mirror 1650. Under command of the controller 1630, the scanner 1640 steps the deflected beam 1626 over the appropriate region of the mirror 1650. At each step the blanker 1635 controls the amount of radiation deposited on the mirror 1650 by the deflected beam 1626. Thus, a controlled and variable intensity distribution can be created at the mirror 1650.

The blanker 1635 may be a rotating mirror which can deflect the collimated beam 1625 into a beam stop (not shown) when blanking is desired by the controller 1630. It may also be an acousto-optic modulator (AOM). An AOM is a crystal, transparent to the radiation of which the index of refraction is periodically modulated by the presence of an ultrasonic sound wave imposed on the crystal from an attached oscillator which is controlled by the controller 1630. The modulations of the index of refraction create an optical grating in the crystal which efficiently diffracts the collimated beam 1625. The response time of the AOM is typically much shorter than that of a rotating mirror.

The scanner 1640 deflects the collimated beam 1625 in orthogonal directions, so the deflected beam 1626 can cover the illuminated region of the mirror 1650. This may be done with rotating mechanical mirrors, employing a galvanometer movement, or the scanner 1640 may employ rotating prisms or acousto-optic modulation, or electro-optic modulation. In one embodiment, for this application, the scanner 1640 will employ galvanometer mirrors.

A summary of information about modulation and scanning of optical beams may be found in Chapter 8 of the book "Elements of Modern Optical Design", by Donald O'Shea (John Wiley & Sons, 1985), the contents of which are incorporated herein by reference.

Under command of the controller 1630, the scanner 1640 deflects the collimated beam 1625 over the illuminated region of the mirror 1650 in small steps, and the blanker 1635 adjusts the energy deposited at each step location. If the time required to step over the entire illuminated region of the mirror 1650 is short compared to the thermal diffusion time of the mirror 1650, the resulting intensity distribution at the mirror 1650 will be equivalent to that of a stationary intensity distribution projected onto the mirror 1650, as might be provided by the embodiments described above. The time variation of the mirror temperature T can be modeled mathematically by assuming the heat flux F to vary periodically with frequency f. The maximum temperature variation occurs at the mirror surface and decreases exponentially with depth z in the mirror, according to the expression

$$T = \sqrt{\frac{\kappa}{\omega}} \frac{F}{K} \exp[-z\sqrt{\omega/2\kappa}], \qquad\qquad (9)$$

where $\omega = 2\pi f$, K is the thermal conductivity of the solid, the thermal diffusivity $\kappa = K/\rho C$, $\rho$ is the density, and C the specific heat capacity. This expression comes from Section II.9 of Carslaw and Jaeger, Conduction of Heat in Solids, the contents of which are incorporated herein by reference.

For a mirror using the glass ULE, made by Corning Inc. of Corning, New York, C = 766 J/kg-K, $\rho$ = 2205 kg/$m^3$, K = 1.31 W/m-K, and $\kappa$ = 7.75x$10^{-7}$ $m^2$/sec. A flux of F = 100 W/$m^2$ was assumed. At a depth of 0.1 mm in the mirror, the temperature variation is less than 0.001 °K at a frequency of 50 Hz, and at a depth of 1 mm in the mirror the temperature variation is less than 0.001 °K at a frequency of only several Hz. Therefore, variations in flux at frequencies higher than these relatively modest numbers will have negligible effect on the mirror temperature. Galvanometer scanners can easily refresh a rastered deflection field at much higher frequencies than that.

Fig. 1A shows an EUV (or soft-X-ray SXR) system 110, including the EUV mirror of this invention as described above. As a lithographic energy beam, the EUV system 110 uses a beam of EUV light of wavelength $\lambda$ = 13 nm. The depicted system is configured to perform microlithographic exposures in a step-and-scan manner.

The EUV beam is produced by a laser-plasma source 117 excited by a laser 113 situated at the most upstream end of the depicted system 110. The laser 113 generates laser light at a wavelength within the range of near-infrared to visible. For example, the laser 113 can be a YAG laser or an excimer laser. Laser light emitted from the laser 113 is condensed by a condensing optical system 115 and directed to the downstream laser-plasma source 117. Upon receiving the laser light, the laser-plasma source 117 generates SXR (EUV) radiation having a wavelength ($\lambda$) of approximately 13 nm with good efficiency.

A nozzle (not shown), disposed near the laser-plasma source 117, discharges xenon gas in a manner such that the discharged xenon gas is irradiated with the laser light in the laser-plasma source 117. The laser light heats the discharged xenon gas to a temperature sufficiently high to produce a plasma that emits photons of EUV light as the irradiated xenon atoms transition to a lower-potential state. Since EUV light has low transmittance in air, the optical path for EUV light propagating from the laser-plasma source 117 is contained in a vacuum chamber 119 normally evacuated to high vacuum. Since debris normally is produced in the vicinity of the nozzle discharging xenon gas, the vacuum chamber 119 desirably is separate from other chambers of the system.

A parabolic mirror 121, coated with a Mo/Si multilayer film, is disposed relative to the laser-plasma source 117 so as to receive EUV light radiating from the laser-plasma source 117 and to reflect the EUV light in a downstream direction as a collimated beam. The multilayer film on the parabolic mirror 121 is configured to have high reflectivity for EUV light of which $\lambda$ = approximately 13 um.

The collimated beam passes through a visible-light-blocking filter 123 situated downstream of the parabolic mirror 121. By way of example, the filter 123 is made of Be, with a thickness of 0.1 $\mu$m. Of the EUV radiation reflected by the parabolic mirror 121, only the desired 13-nm wavelength of radiation passes through the filter 123. The filter 123 is contained in a vacuum chamber 125 evacuated to high vacuum.

An exposure chamber 143 is disposed downstream of the filter 123. The exposure chamber 143 contains an illumination-optical system 127 that comprises a condenser mirror and a fly-eye mirror (not shown, but well understood in the art). The illumination-optical system 127 also is configured to trim the EUV beam (propagating from the filter 123) to have an arc-shaped transverse profile. The shaped "illumination beam" is irradiated toward the left in the figure.

A circular, concave mirror 129 is situated so as to receive the illumination beam from the illumination-optical system 127. The concave mirror 129 has a parabolic reflective surface 129a and is mounted perpendicularly in the vacuum chamber 143. The concave mirror 129 comprises, for example, a quartz mirror substrate of which the reflection surface is machined extremely accurately to the desired parabolic configuration. The reflection surface of the mirror substrate is coated with a Mo/Si multilayer film so as to form the reflective surface 129a that is highly reflective to EUV radiation of which $\lambda$ = 13 nm. Alternatively, for other wavelengths in the range of 10-15 nm, the multilayer film can be of a first substance such as Ru (ruthenium) or Rh (rhodium) and a second substance such as Si, Be (Beryllium) or $B_4C$ (carbon tetraboride).

A mirror 131 is situated at an angle relative to the concave mirror 129 so as to received the EUV beam from the concave mirror 129 and direct the beam at a low angle of incidence to a reflective reticle 133. The reticle 133 is disposed horizontally so that its reflective surface faces downward in the figure. Thus, the beam of EUV radiation emitted from the illumination-optical system 127 is reflected and condensed by the concave mirror 129, directed by the mirror 131, and focused don the reflective surface of the reticle 133.

The reticle 133 includes a multilayer film so as to be highly reflective to incident EUV light. A reticle pattern, corresponding to the pattern to be transferred to a substrate 139, is defined in an EUV-absorbing layer formed on the multiplayer film of the reticle 133, as discussed later below. The reticle 133 is mounted to a reticle stage 135 that moves the reticle 133 at least in the Y direction. The reticle 133 normally is too large to be illuminated entirely during a single exposure "shot" of the EUV beam. As a result of the mobility of the reticle.stage 135, successive regions of the reticle 133 can be irradiated sequentially so as to illuminate the pattern in a progressive manner with EUV light from the mirror 131.

A projection-optical system 137 and substrate (such as a semiconductor wafer) 139 are disposed in that order downstream of the reticle 133. The projection-optical system 137 comprises multiple multilayer-film reflective mirrors that collectively demagnify an aerial image of the illuminated portion of the pattern on the reticle 133. The demagnification normally is according to a predetermined demagnification factor such as 1/4. The projection-optical system 137 focuses an aerial image of the illuminated pattern portion onto the surface of the substrate 139. Meanwhile, the substrate 139 is mounted to a substrate stage 141 that is movable in the X, Y, and Z directions.

Connected to the exposure chamber 143 via a gate valve 145 is a preliminary-evacuation ("load-lock" chamber 147. The load-lock chamber 147 allows exchanges of the reticle 133 and/or substrate 139 as required. The load-lock chamber 147 is connected to a vacuum pump 149 that evacuates the load-lock chamber 147 to a vacuum level substantially equal to the vacuum level inside the exposure chamber 143.

During a microlithographic exposure, EUV light from the illumination-optical system 127 irradiates the reflective surface of the reticle 133. Meanwhile, the reticle 133 and substrate 139 are moved by their respective stages 135 and 141 in a synchronous manner relative to the projection-optical system 137. The stages 135 and 141 move the reticle 133 and the substrate 139, respectively, at a velocity ratio determined by the demagnification factor of the projection-optical system 137. Thus, the entire circuit pattern defined don the reticle 133 is transferred, in a step-and-scan manner, to one or more "die" or "chip" locations on the substrate 139. By way of example, each "die" or "chip" on the substrate 139 is a square having 25-mm sides. The pattern is thus" transferred" from the reticle 133 to the substrate at very high resolution (such as sufficient to resolve a 0.07-$\mu$m line-and-space (L/S) pattern). So as to be imprintable with the projected pattern, the upstream-facing surface of the substrate 139 is coated with a suitable "resist."

In the system 110 of Fig. 1A at least one multilayer-film optical element as described above is included in at least one of the illumination-optical system 127, the reticle 133, and the projection-optical system 137.

Fig. 1C shows another embodiment of an X-ray (specifically EUV) microlithography system utilizing one or more multilayer-film reflective optical elements as described herein and comprising a EUV source S, an illumination-optical system (comprising elements GI and IR1-IR4), a reticle stage MST for holding a reticle M, a projection-optical system (comprising elements PR1 -PR4) and a substrate stage WST for holding a substrate W (such as a semiconductor wafer).

The EUV source S generates an illumination beam IB of EUV light. To such end, a laser LA generates and directs a high-intensity laser beam LB (near-IR to visible) through a lens L to the discharge region of a nozzle T that discharges a target substance such as xenon. The irradiated target substance forms a plasma that emit photons of EUV light that constitute the illumination beam IB. The illumination beam IB is reflected by a parabolic multilayer-film mirror PM to a window W1. The EUV source S is contained in a chamber C1 that is evacuated to a suitably high vacuum by means of a vacuum pump (not shown). The illumination beam IB passes through the window W1 to the interior of an optical-system chamber C2.

The illumination beam IB then propagates to the illumination-optical system comprising mirrors GI, IR1, IR2, IR3 and IR4. The mirror GI is a grazing-incidence mirror that reflects the grazing-incident illumination beam IB from the EUV source S. (Alternatively, the mirror GI can be a multilayer-film mirror.) The mirrors IR1, IR2, IR3 and IR4 are multilayer-film mirrors each including a surface multilayer film exhibiting high reflectivity to incident EUV radiation, as described elsewhere herein. The illumination-optical system also comprises a filter (not shown) that is transmissive only to EUV radiation of a prescribed wavelength. The illumination-optical system directs the illumination beam IB, having the desired wavelength, to a selected region on the reticle M. The reticle M is a reflective reticle including a multilayer film. The beam reflected from the reticle M carries an aerial image of the illuminated region of the reticle M; hence the reflected beam is termed a patterned beam.

The projection-optical system comprises multiple multilayer-film mirrors PR1, PR2, PR3 and PR4 that collectively project an image of the illuminated portion of the reticle M onto a corresponding location on the substrate W. Thus, the pattern defined by the reticle M is transfer-exposed onto the substrate W. Note that several of the mirrors PR1-PR4 (specially the mirrors PR1 and PR4) have a cutout allowing the patterned beam unobstructed passage in the projection-optical system. So as to be imprintable with the projected pattern, the substrate W is coated with an exposure-sensitive resist. Since EUV radiation is absorbed and attenuated in the atmosphere, the environment in the optical-system chamber C2 is maintained at a suitably high vacuum (such as $10^{-5}$ Torr or less). Actual exposure of the substrate W can be performed in a "step-and-repeat," "step-and-scan," or pure s canning-exposure manner, or other suitable manner, all of which involving controlled movements of the reticle stage MST and substrate stage WST relative to each other as transfer-exposure of the pattern progresses. During exposure, the substrate W is situated in a separate chamber C3, termed a "substrate chamber" or "wafer chamber," that contains the substrate stage WST. As the patterned beam PB enters the substrate chamber C3 from the optical-system chamber C2, the beam passes through a window W2.

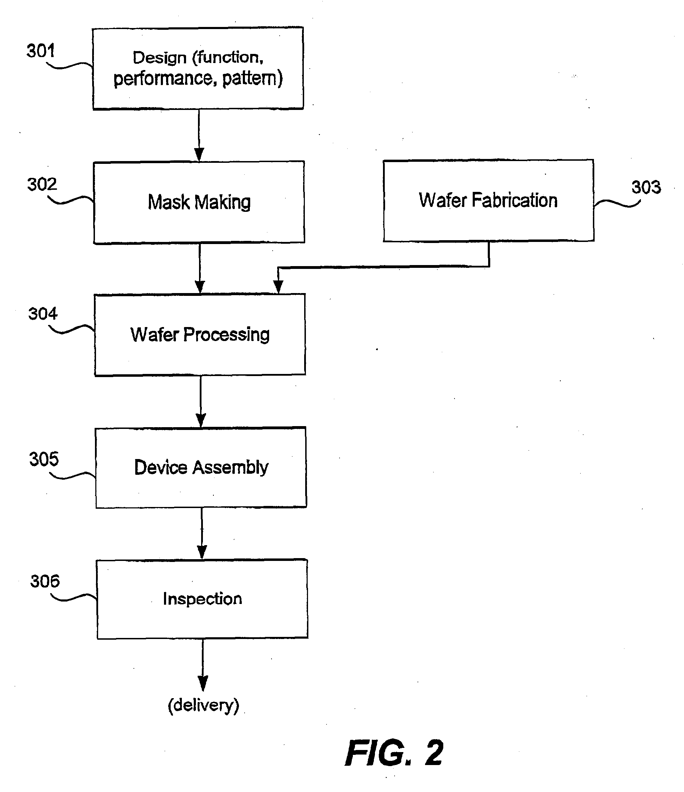

Further, semiconductor devices can be fabricated using the above described systems, by the process shown generally in Fig. 2. In step 301 the device's function and performance characteristics are designed. Next, in step 302, a mask (reticle) having a pattern is designed according to the previous designing step, and in a parallel step 303, a wafer is made from a silicon material. The mask pattern designed in step 302 is exposed onto the wafer from step 303 in step 304 by a photolithography system such as the systems described above. In step 305 the semiconductor device is assembled (including the dicing process, bonding process and packaging process), then finally the device is inspected in step 306.

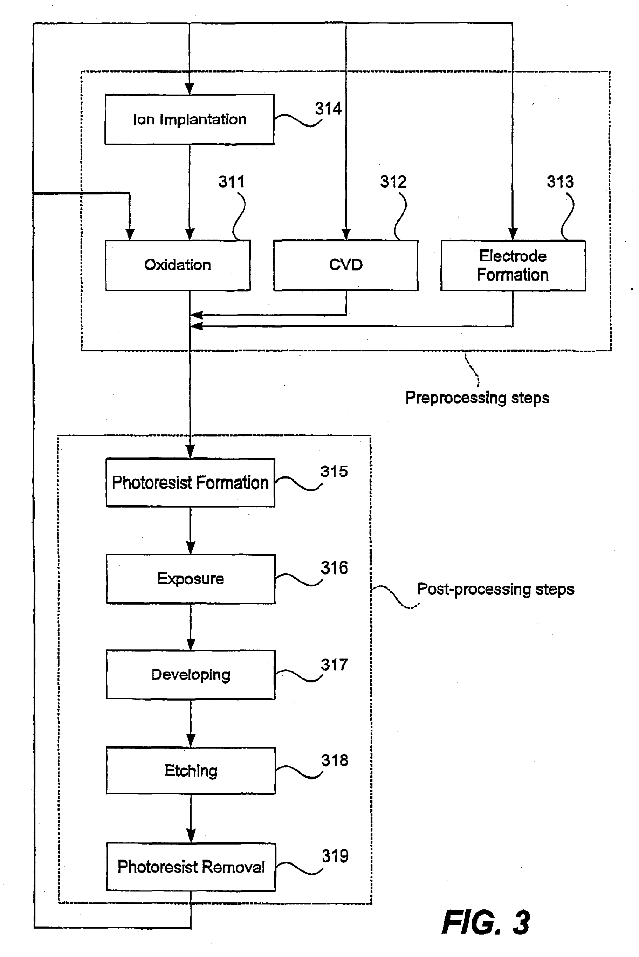

Fig. 3 illustrates a detailed flowchart example of the above-mentioned step 304 in the case of fabricating semiconductor devices. In step 311 (oxidation step), the wafer surface is oxidized. In step 312 (CVD step), an insulation film is formed on the wafer surface. In step 313 (electrode formation step), electrodes are formed on the wafer by vapor deposition. In step 314 (ion implantation step), ions are implanted in the wafer. The above mentioned steps 311-314 form the preprocessing steps for wafers during wafer processing, and selection is made at each step according to processing requirements.

At each stage of wafer processing, when the above-mentioned preprocessing steps have been completed, the following post-processing steps are implemented. During post-processing, initially, in step 315 (photoresist formation step), photoresist is applied to a wafer. Next, in step 316, (exposure step), the above-mentioned exposure device is used to transfer the circuit pattern of a mask (reticle) to a wafer. Then, in step 317 (developing step), the exposed wafer is developed, and in step 318 (etching step), parts other than residual photoresist (exposed material surface) are removed by etching. In step 319 (photoresist removal step), unnecessary photoresist remaining after etching is removed. Multiple circuit patterns are formed by repetition of these preprocessing and post-processing steps.

While this invention has been described in terms of several preferred embodiments, there are alterations, permutations, and various substitute equivalents which fall within the scope of this invention. It should also be noted that there are many alternative ways of implementing the methods and apparatuses of the present invention. It is therefore intended that the following appended claims be interpreted as including all such alterations, permutations, and various substitute equivalents as fall within the true spirit and scope of the present invention.

**Claims**

1. An apparatus comprising:

   a mirror having a reflective surface and a body, at least one channel being formed in the body of the mirror; and

   a conduit inside the one channel configured to distribute a cooling fluid through the channel, a gap being formed between the conduit and the channel in the body of the mirror, the gap configured to be maintained at a pressure sufficiently low to substantially prevent distortion of the reflective surface or body of the mirror.

2. The apparatus of claim 1 wherein the pressure maintained within the gap is substantially the same as the ambient pressure surrounding the mirror.

3. The apparatus of claim 1 wherein the pressure within the conduit distributing the cooling fluid is higher or substantially the same as the pressure maintained within the gap.

4. The apparatus of claim 1 wherein the pressure within the conduit distributing the cooling fluid is lower or substantially the same as the pressure maintained within the gap.

5. The apparatus of claim 1 wherein the gap surrounds the conduit within the body of the mirror and the conduit is prevented from contacting the body of the mirror.

6. The apparatus of claim 3 wherein the gap is filled with a thermally conductive gas.

7. The apparatus of claim 3 wherein the gap is filled with a thermally conductive liquid.

8. The apparatus of claim 6 wherein the gap is concentrically formed around the conduit within the body of the mirror.

9. The apparatus of claim 1 comprising a plurality of channels, each of the channels including a conduit and having a gap formed between the channel and the conduit.

10. The apparatus of claim 1 wherein the reflective surface of the mirror is configured to reflect energy having a wavelength ranging from 20 microns to one Angstrom.

11. The apparatus of claim 1 wherein the reflective surface of the mirror is configured to reflect energy having a wavelength in the EUVL range.

12. The apparatus of claim 1 further comprising a spacer formed between the conduit and the channel to prevent the conduit from contacting the body of the mirror.

13. The apparatus of claim 12 wherein the spacer is made of an energy absorbing material wherein energy of vibrations inside the channel is thereby absorbed.

14. The apparatus of claim 12 wherein the spacer is made of a visco-elastic material.

15. The apparatus of claim 1 wherein the one channel includes a plurality of conduits each configured to distribute cooling fluid through the channel.

16. A method of minimizing hermal distortion effects on a mirror, said method comprising the steps of:

   providing channels through said mirror;
   causing a cooling fluid to flow through said channels; providing coolant pipes inside said channels, said coolant pipes not contacting inner walls of said channels, said cooling fluid being caused to flow inside said coolant pipes.

17. The method of claim 16 further comprising the step of preliminarily polishing a reflecting surface of said mirror while said channels are over-pressurized by a specified amount.

18. The method of claim 16 wherein each of said coolant pipes and a corresponding one of said inner walls are separated by a gap of less than 100μm in width.

19. The method of claim 16 wherein said channels are formed proximally to a reflecting surface of said mirror.

20. The method of claim 16 further comprising the step of filling the gap region with a gas to conduct heat between said inner walls and said coolant pipes.

21. The method of claim 16 wherein said mirror has a reflecting surface for reflecting EUV radiation and a back surface opposite said reflecting surface, said method further comprising the steps of monitoring radiation on said reflecting surface and causing said back surface to be selectively heated according to the monitored radiation on said reflecting surface.

22. The method of claim 21 wherein the step of causing comprises providing a collimated beam of radiation and blanking said collimated beam according to the monitored radiation on said reflecting surface.

23. An EUV system comprising:

   an EUV radiation source;
   a reticle stage arranged to retain a reticle;
   a working stage arranged to retain a workpiece; and
   an optical system including at least one mirror that includes a reflecting surface for reflecting EUV radiation from said EUV radiation source and a back surface opposite said reflecting surface, there being channels formed within said mirror member, and a cooling fluid that passes through said channels, said optical system serving to cause said EUV radiation to be reflected by said reticle and to thereby impinge on said workpiece.

24. The EUV system of claim 23 wherein said reflecting surface is polished when said channels are over-pressurized by a specified amount.

**25.** The EUV system of claim 23 wherein said channels each have an inner wall and contain a coolant pipe, said cooling fluid passing through said coolant pipe, said coolant pipe and said inner wall not contacting each other, there being a gas provided between said coolant pipe and said inner wall.

**26.** The EUV system of claim 25 wherein said coolant pipe and said inner wall are separated by a gap with a width of less than 100μm.

**27.** An object manufactured with the EUV system of claim 23.

**28.** A wafer on which an image has been formed by an EUV system of claim 23.

**29.** A method for making an object using a lithography process, wherein the lithography process utilizes an EUV system as recited in claim 23.

**30.** A method for patterning a wafer using a lithography process, wherein the lithography process utilizes an EUV system as recited in claim 23.

**31.** An apparatus, comprising:

a mirror body;

a reflective surface formed on the body, the reflective surface configured to receive and reflect radiation in the EUV wavelength range; and

a second surface formed on the mirror body, adjacent the reflection surface, the second surface having its temperature selectively adjusted to reduce thermal distortions of the reflective surface.

**32.** The apparatus of claim 31, wherein the second surface has its temperature selectively raised to reduce localized thermal distortions of the reflective surface.

**33.** The apparatus of claim 31, further comprising channels formed in the mirror body, and pipes formed within the channels but not contacting the inner walls of the channels, the pipes configured to pipe cooling fluid through the body of the mirror to reduce the overall temperature of the body of the mirror.

**FIG. 1A**

**FIG. 1B**

**FIG. 1C**

301 — Design (function, performance, pattern)

302 — Mask Making

303 — Wafer Fabrication

304 — Wafer Processing

305 — Device Assembly

306 — Inspection

(delivery)

*FIG. 2*

Ion Implantation  ~314

311  312  313

Oxidation  CVD  Electrode Formation

Preprocessing steps

Photoresist Formation  ~315

Exposure  316

Developing  317

Etching  318

Photoresist Removal  319

Post-processing steps

*FIG. 3*

**FIG. 4**

**FIG. 5A**

**FIG. 5B**

**FIG. 6**

Heat Transfer Coefficients for 4 mm Tube Fluorinert FC-3283

FIG. 7

EP 1 376 185 A2

FIG. 8A

FIG. 8B

FIG. 8C

FIG. 8D

FIG. 9A

**FIG. 9B**

**FIG. 10**

$T_1(x,y)$

Cooling plane 1

$t_1$

Cooling plane 2

Cooling channels

$T_2(x,y)$

$t_2$

## FIG. 11

$F_1$

$F_2$

x

x

$\overline{x}$

1240

Detector
1220

1210

1200

Controller

Heater

1250

## FIG. 12

**FIG. 13**

**FIG. 14**

**FIG. 15**

**FIG. 16**